**Europäisches Patentamt**

**European Patent Office**

**Office européen des brevets**

(19)

(11) Publication number: **0 037 734**

**B1**

(12) **EUROPEAN PATENT SPECIFICATION**

(45) Date of publication of patent specification: **30.12.86**

(51) Int. Cl.⁴: **G 11 C 11/40,** G 11 C 7/00

(21) Application number: **81301494.1**

(22) Date of filing: **07.04.81**

(54) **Semiconductor memory chip, and a memory device including such chips.**

(30) Priority: **08.04.80 JP 45826/80**

(43) Date of publication of application:
**14.10.81 Bulletin 81/41**

(45) Publication of the grant of the patent:
**30.12.86 Bulletin 86/52**

(84) Designated Contracting States:
**DE FR GB**

(56) References cited:
**US-A-3 729 721**
**US-A-4 099 070**

**IEEE JOURNAL OF SOLID-STATE CIRCUITS,
vol. SC-14, no. 5, October 1979, pages 850-854,
New York (USA); H. GLOCK et al.: "An ECL
100K-compatible 1024 x 4 bit RAM with 15 ns
access time".**

(73) Proprietor: **FUJITSU LIMITED**
**1015, Kamikodanaka Nakahara-ku**
**Kawasaki-shi Kanagawa 211 (JP)**

(72) Inventor: **Yamada, Katsuyuki**
**2063, Shimosakunobe Takatsu-ku**
**Kawasaki-shi Kanagawa 213 (JP)**
Inventor: **Isogai, Hideaki**
**11-13, Minamisawa 4-chome Higashikurume-shi**
**Tokyo 180-03 (JP)**

(74) Representative: **Sunderland, James Harry et al**
**HASELTINE LAKE & CO Hazlitt House 28**
**Southampton Buildings Chancery Lane**
**London WC2A 1AT (GB)**

## Description

This invention relates to a semiconductor memory chip, and a memory device including such chips.

With a view to providing increased memory capacity, attempts have been made to form a memory device in which a plurality of semiconductor memory chips are combined.

When such an attempt is made, although the memory device provides a large capacity, only one chip therein is selected, so that a memory cell in a selected chip can be written or read. Other chips, and memory cells of those chips, are not selected. However, an address, for reading or writing is given to all chips, whether selected or not selected, and a word line of a non-selected chip corresponding to the selected word line of the selected chip becomes H level. At a time when this is taking place, therefore, if noise occurs on a bit line, problems such as erroneous writing can sometimes occur. In a conventional static memory in which each memory cell comprises a flip-flop circuit, bit line voltage in a non-selected chip has been the same as bit line voltage in a selected chip in read operation, and therefore information in a cell of a non-selected chip is also read onto a bit line of that chip, as information in a cell of a selected chip is read onto a bit line of the selected chip.

If negative noise appears on a bit line for any reason, a transistor in an OFF condition in a flip-flop type memory cell can turn ON. As a result, a transistor on the ON side of the memory cell may turn OFF. Namely, stored information may be destroyed.

Attention is directed to IEEE Journal of Solid State Circuits, Volume SC-14, No. 5, October 1979, pages 850 to 854.

Power supply line noise or noise on signal lines due to, for example, a variation of input data or of address signal, can appear on bit lines.

The prevention of destruction of information stored in memory cells of a non-selected chip is clearly desirable.

US—A—4 099 070 discloses a sense-write circuit for a random access memory. It is particularly concerned with the provision of a sense-write circuit for an ECL memory which utilizes differential stages in a tree configuration such that only one current source is provided.

Although US—A—4 099 070 describes a sense-write circuit for an ECL memory which has a chip select function it does not disclose or address any problem which may arise during chip non-selection.

In US—A—4 099 070 an ECL memory is disclosed which has a chip select facility and memory cells arranged in rows and columns at intersection points of row-selection conductors 60A and bit-sense lines extending down columns 50, 51. Attention is directed particularly to the Figure of US—A—4 099 070. Transistors 45, 48 are provided which are connected to bit-sense lines 50, 51 and the bases of which during reading of a memory cell of the memory when chip selected are clamped to a sense voltage of −1,3V, this sense voltage lying midway between the H and L voltage levels of the memory cells. Analysis of the circuitry shown in the Figure of US—A—4 099 070 suggests that when the memory is chip non-selected, transistor 15 is switched off under control of a chip select signal, thereby inhibiting current flow through circuit paths 20 and 21. This should apparently lead to an increase of potential at nodes 30, 31 to approximately $V_{CC}$ ($V_{CC}$=positive supply voltage=0V), which is apparently transmitted through emitter followers 36, 38 to the bases of the transistors 45, 48. Hence the bases of the transistors 45, 48 appear to be clamped to a voltage level of $V_{CC}$−$VB_{BE}$ ($V_{BE}$=base emitter voltage of transistors 36 and 38). Since $V_{CC}$=0V and $V_{BE}$≤0.7V, this clamping level is apparently higher than the above mentioned sense voltage of −1,3V and therefore the bit-sense lines 50, 51 connected to transistors 45, 48, appear to be at a voltage level higher than the voltage level during a read operation.

Thus, a theoretical analysis of the circuitry shown in the Figure of US—A—4 099 070 (which circuitry will represent only a small part of the total circuitry of a complete memory) suggests that when a chip on which the ECL memory is formed is non-selected bit-sense line voltage may be set to a voltage higher than bit line voltage level during a read operation. It also suggests that this is accomplished by setting the base voltage of transistors 45 and 58.

According to the present invention there is provided a semiconductor memory chip, having a chip select facility, including memory cells arranged at intersection points of word lines and bit lines of the chip, and bit line selection transistors connected to the bit lines, the chip further including clamp means which are operable, when the chip is non-selected, to clamp bit line voltage to a level higher than the bit line voltage level during a read operation when the chip is selected, the clamp means being arranged and operable for clamping the base voltage of the bit line selection transistors.

According to the present invention there is also provided a semiconductor memory chip, having a chip select facility, including memory cells arranged at intersection points of word lines and bit lines of the chip, and with a plurality of bit line pairs having respective read transistor pairs connected thereto, and a pair of data lines, connected to the bases of the transistors of each read transistor pair, the chip further including clamp means which are operable to clamp the data lines and comprise a multi-emitter transistor having respective emitters connected to respective data lines, a collector connected to a high level power supply line and a base connected to receive a voltage which turns the multi-emitter transistor ON when the chip is non-selected and which turns the multi-emitter transistor OFF when the chip is selected, whereby when the chip is non-selected, bit line voltage is clamped to a level higher than the bit line voltage level during a read operation when the chip is selected.

According to the present invention there is also provided a semiconductor memory chip, having a chip select facility, including memory cells arranged at intersection points of word lines and bit lines of the chip, and with a plurality of bit line pairs having respective read transistor pairs connected thereto, and a pair of data lines, connected to the bases of the transistors of each read transistor pair, the chip further including clamp means which are operable to clamp the data lines and comprise a pair of current switches connected to respective data lines and arranged so that they are ON for passage of a high level voltage to the data lines, when the chip is non-selected and are OFF for passage of that high level voltage when the chip is selected, whereby when the chip is non-selected, bit line voltage is clamped to a level higher than the bit line voltage level during a read operation when the chip is selected.

The present invention can provide a semiconductor memory device including a plurality of such chips.

An object of the present invention is to offer a static semiconductor memory device in which the incidence of destruction of information stored in cells of the device is reduced.

An object of the present invention is to offer a semiconductor memory device in which influence of disturbances on memory cells of a non-selected chip is reduced, and which has a high memory cell holding margin.

An object of the present invention is to offer a semiconductor memory device in which simple means are employed to provide a large memory cell holding margin.

Reference is made, by way of example, to the accompanying drawings, in which:—

Figure 1 illustrates a memory device formed using a plurality of semiconductor memory chips, to which an embodiment of the present invention can be applied,

Figure 2 is a schematic diagram of a memory area of a first memory device embodying the present invention,

Figure 3 is a schematic diagram of a READ/WRITE control circuit of the first memory device whose memory cell area is illustrated in Figure 2,

Figure 4 is a voltage level chart for assistance in explanation of an embodiment of the present invention,

Figure 5 is a schematic diagram of a READ/WRITE control circuit of a second memory device embodying the present invention, and

Figure 6 is a schematic diagram of a third memory device embodying the present invention.

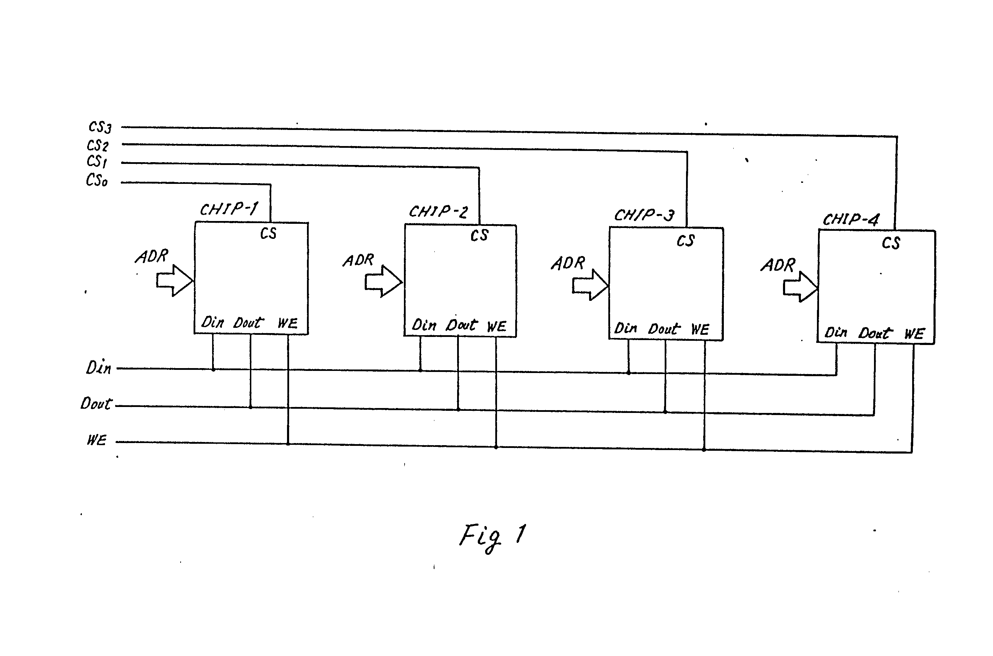

Figure 1 illustrates a memory device formed using four semiconductor chips. CHIP-1 to CHIP-4 are semiconductor memory chips and each chip has a CS terminal, the CS terminals of CHIP-1 to CHIP-4 are arranged to receive chip select signals $CS_0$ to $CS_3$ respectively, a $D_{in}$ terminal for receiving a data signal $D_{in}$, a WE terminal for receiving a write enable signal WE, and a $D_{out}$ terminal for output of a data output signal $D_{out}$.

An address signal ADR is applied in common to all the chips CHIP-1 to CHIP-4. Since the address signal ADR is input in common to the chips, the address of one cell in each chip is designated, but only one of the chips is selected, by means of chip select signals $CS_0$ to $CS_3$, and thereby input data signal $D_{in}$ is written into and/or output signal $D_{out}$ is read out of only the selected chip. Namely, a write operation for writing input data $D_{in}$, and/or a read operation for output of output data $D_{out}$, is inhibited at a non-selected chip by the relevant chip select signal.

An embodiment of the present invention relates to a semiconductor memory chip suitable for use in a structure wherein a plurality of semiconductor memory chips are combined, for example as shown in Figure 1. A semiconductor memory chip embodying this invention can offer improved circuits within the chip and can assure high memory cell holding margin.

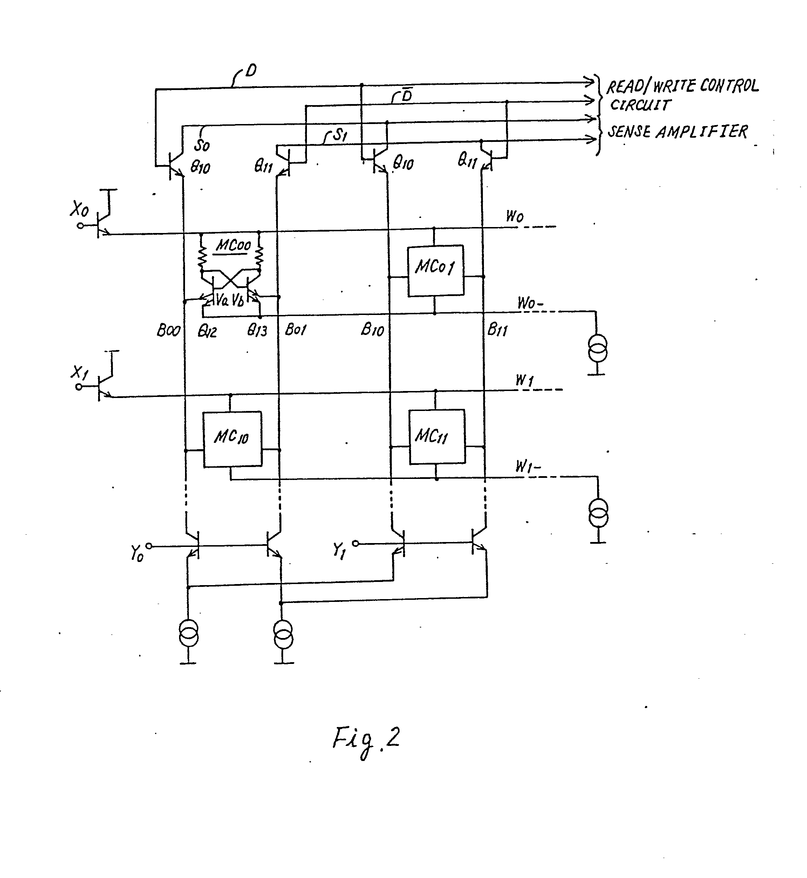

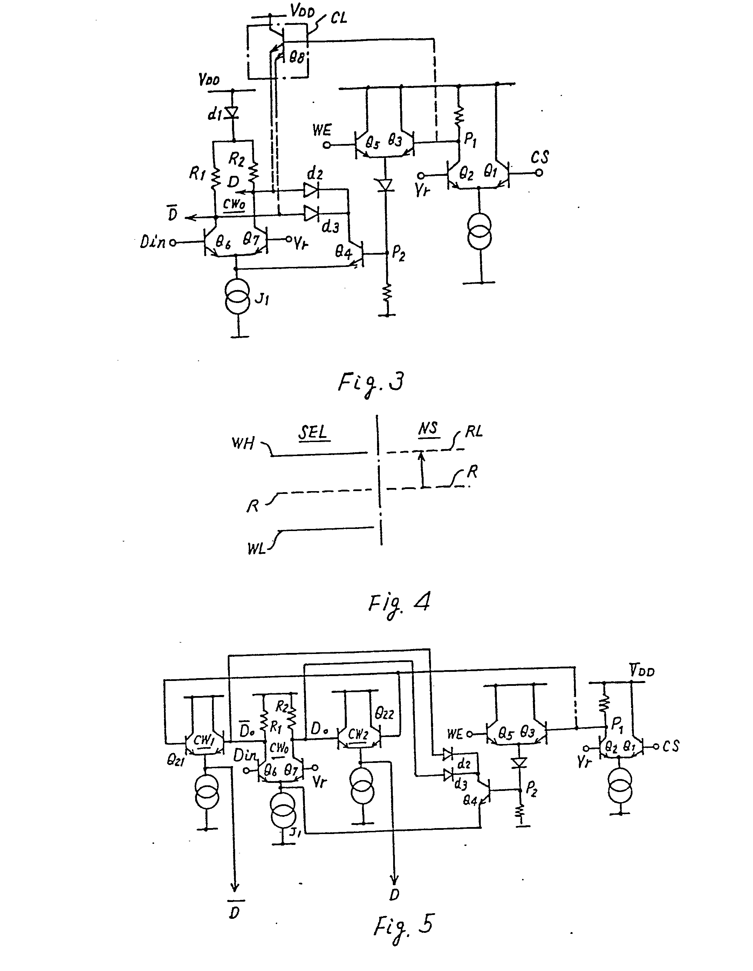

Figure 2 is a schematic diagram of a memory cell area of a static semiconductor memory embodying the present invention, and Figure 3 is a schematic diagram of a READ/WRITE control circuit of the memory. Figure 4 is a voltage level chart for assistance in explanation of the memory of Figures 2 and 3.

In the embodiment of Figures 2 and 3, a clamp circuit CL is provided as shown in Figure 3, the structure of the circuitry shown in Figure 2 and that of circuits other than CL in Figure 3 is generally conventional.

An embodiment of the present invention will be explained with reference, for comparison purposes, to a conventional structure.

In one example of a conventional circuit structure, a read level (e.g. base voltage of a read transistor connected to a bit line, except when data is being written in through the read transistor in a memory chip) has been the same whether the memory chip is or is not selected. Namely, in this case, bit line voltage in non-selected chips has been the same as bit line voltage in a selected chip, during a read operation.

The voltage chart of Figure 4 is for assistance in explaining this relationship. In this Figure, SEL indicates a part of the chart relating to a case in which a chip is selected, whilst NS indicates a part of the chart relating to a case in which a chip is not selected. WH is a H(high) write level corresponding, for example, to data "1", whilst WL is a L(low) write level, in this example, corresponding to data "0". A read level R is set mid-way between WH and WL and, as indicated in Figure 4, has been held at the same value for selected and not selected chip states. Figure 3 shows a READ/WRITE control circuit for generating levels represented in Figure 4.

In the circuit of Figure 3, when a chip is not selected, chip selection signal CS becomes H (high) level, a transistor $Q_1$ is ON, a transistor $Q_2$ is

OFF, and a point $P_1$ is H level. As a result, whether the write enable signal WE is L (low) level, which low level instructs a write operation, or H (high) level, which high level instructs a read operation, a point $P_2$ becomes H level, and thus a transistor $Q_4$ is ON, and as a result whether input data signal $D_{in}$ is H or L, data lines D, $\bar{D}$ are set to a constant level (R level in Figure 4) which is determined by a power supply voltage $V_{DD}$, a diode $d_1$, resistors $R_1$, $R_2$, diodes $d_2$, $d_3$, transistor $Q_4$ and a constant current source $J_1$.

When a chip is selected, CS is L level, therefore $Q_1$ is OFF, $Q_2$ is ON, and point $P_1$ is L level. As a result, a transistor $Q_5$, which receives the write enable signal WE, becomes effective. Moreover, when WE becomes L level, in a write operation, point $P_2$ becomes L level and $Q_4$ is OFF. Thus, a transistor $Q_6$ of a current switch $CW_0$ becomes ON or OFF, whilst another transistor $Q_7$ of the current switch becomes OFF or ON, and data lines D, $\bar{D}$ become H or L level in accordance with the level, H or L, of input data $D_{in}$ namely in dependence upon the data being "1" or,"0". These H and L levels are represented by WH, WL in Figure 4.

When a chip is selected and read operation starts, in other words, when WE is H level, the point $P_2$ becomes H level, transistor $Q_4$ is ON and the data lines D, $\bar{D}$ become R level as indicated above.

The D, $\bar{D}$ lines supply a reference voltage to read transistors $Q_{10}$, $Q_{11}$ inserted between bit lines $(B_{00}, B_{01})$ $(B_{10}, B_{11})$ as seen in Figure 2. Namely, when a memory cell $MC_{00}$ is selected in Figure 2, read transistors $Q_{10}$, $Q_{11}$ connected to bit lines $B_{00}$, $B_{01}$ form a current switch in combination with transistors $Q_{12}$, $Q_{13}$ of the memory cell $MC_{00}$. In read operation, when $Q_{12}$ is ON, $Q_{13}$ is OFF (at this time, $V_a$ (collector voltage of $Q_{13}$, connected to base of $Q_{12}$)=H level, $V_b$ (collector voltage of $Q_{12}$, connected to base of $Q_{13}$)=L level), $Q_{10}$ becomes OFF and $Q_{11}$ becomes ON (because a selection is made such that $V_a>R$, $V_b<R$). Thus a current does not flow into a signal line $S_0$ of a sense amplifier, but a current does flow into a signal line $S_1$ of the sense amplifier. When $Q_{12}$ is OFF and $Q_{13}$ is ON, on the contrary, lines $S_0$, $S_1$ pass current in a reverse arrangement. Thereby the sense amplifier reads the storage condition, "1" or "0", of the memory cell $MC_{00}$.

For a write operation, for example, a transistor state in which $Q_{12}$ is originally ON and $Q_{13}$ is originally OFF must be reversed (there is no change if the transistors are to be written in the original state) by setting the data line D to H level, and the data line $\bar{D}$ to L level. Thus, $Q_{10}$ becomes ON, $Q_{12}$ OFF, $Q_{11}$ OFF and $Q_{13}$ ON.

In Figure 2, the memory cells $MC_{10}$, $MC_{01}$, $MC_{11}$ ... are structured in the same way as the memory cell $MC_{00}$. In Figure 2, $W_0$, $W_1$, ... are word lines, whilst $W_{0-}$, $W_{1-}$, ... are holding lines. A word line is selected when an X address selection signal $X_0$, $X_1$, ... becomes H level. Moreover, a bit line pair $(B_{00}, B_{01})$, $(B_{10}, B_{11})$ ... is selected when a Y address selection signal $Y_0$, $Y_1$, ... becomes H level. In relation to the above explanation it will be understood that only memory cell $MC_{00}$ is selected and therefore only $X_0$, $Y_0$ are at the H level, other X address selection signals and Y address selection signals are all at the L level.

In such a static memory, even when a chip is not selected, a voltage is applied to the word lines $W_0$, $W_1$, ... and to the holding lines $W_{0-}$, $W_{1-}$, ... in order to hold the storage condition, and one of transistors $Q_{12}$, $Q_{13}$ in each of the memory cells is ON, whilst the other is OFF. Therefore, when a memory cell $MC_{00}$ is selected and the word line $W_0$ becomes H level, if negative noise appears on bit lines $B_{00}$, $B_{01}$, the OFF transistor may become ON and, as a result, the ON transistor may become OFF. Namely, stored information may be destroyed. Such noise often results from a change of input data and address signals.

The embodiments of the present invention are intended to offer an improvement in relation to this disadvantage. In an embodiment of the present invention, it is intended to reduce the effects of disturbance on a memory cell and to ensure a large memory cell holding margin by making the read (R) level higher in the non-selected condition. In more detail, a bit line clamp level, higher than the read level R in a selected condition, as indicated by RL in Figure 4, is used. The degree to which read level is increased in the non-selected condition is not limited, and it can simply be provided, for example as shown in Figure 3, by the provision of a clamp circuit CL consisting of a transistor $Q_8$ and connected as shown. Namely, when a chip is not selected, the transistor $Q_8$ clamps the data lines D, $\bar{D}$ to $V_{DD}-V_{BE}$ level because CS is H level, and $P_1$ is H level (where $V_{BE}$ is the base-emitter voltage of transistor $Q_8$).

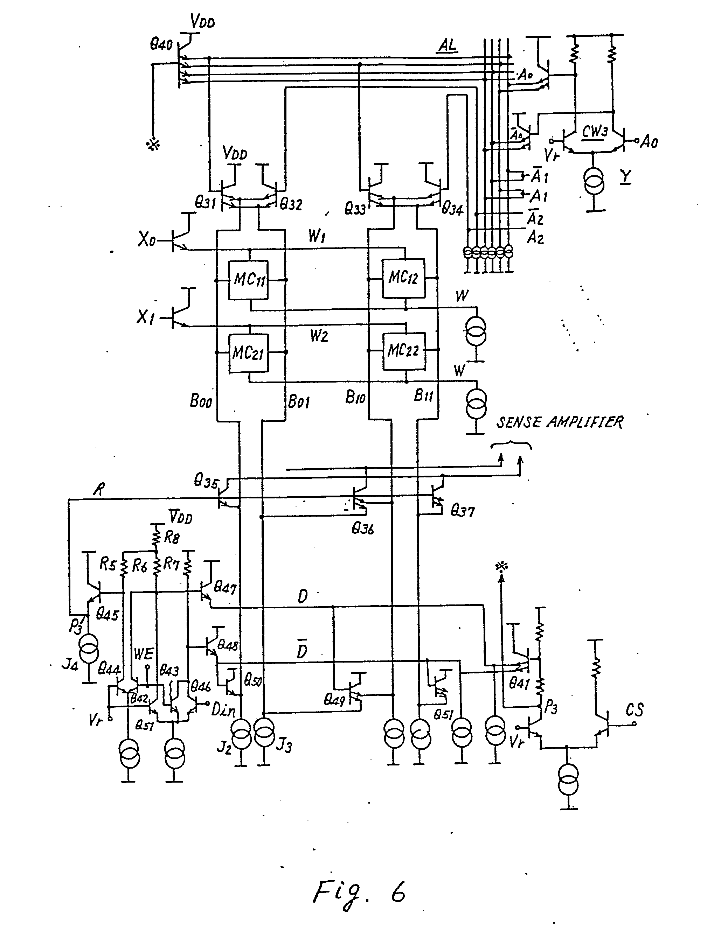

Figure 5 illustrates READ/WRITE control circuitry of another embodiment of the present invention. In this embodiment, current switches $CW_1$, $CW_2$ are added to a conventional circuit structure—other parts of the circuitry correspond almost exactly to Figure 3 (accurately, the diode $d_1$ used in Figure 3 is omitted).

In the circuitry of Figure 5, when CS=H level in a chip non-selected condition, point $P_1$ is H level and transistors $Q_{21}$, $Q_{22}$ are ON. Thereby the base voltage of the transistors $Q_{10}$, $Q_{11}$ in the bit lines of Figure 2 is increased to almost the level of $V_{DD}-V_{BE}$ ($V_{BE}$ is a base-emitter voltage of $Q_{21}$ and $Q_{22}$). When a chip is selected, CS=L level, $P_1$=L level, $Q_{21}$, $Q_{22}$ are OFF and thereby the H, L levels of the lines D, $\bar{D}$, determined by the value "1" or "0" of the input data, are applied to the transistors $Q_{10}$, $Q_{11}$.

Figure 6 illustrates a further embodiment of the present invention.

$MC_{11}$ to $MC_{22}$ are memory cells which are selected by word lines $W_1$, $W_2$ and bit line pairs $B_{00}$ and $B_{01}$, $B_{10}$, $B_{11}$. Of course many word lines, bit lines and memory cells are provided. However, in Figure 6, only four memory cells are indicated. In the case of the memory cells in Figure 6, a word line is selected by addresses $X_0$, $X_1$, while bit lines are selected by Y addresses $A_0$,

$A_1$ and $A_2$. A current switch $CW_3$ generates $A_0$ and inverted $\overline{A}_0$. Similar circuits are also provided (although they are not illustrated) for address bits $A_1$, $A_2$ to generate $A_1$, $\overline{A}_1$ and $A_2$, $\overline{A}_2$ and these are connected to wiring AL. Transistors $Q_{31}$, $Q_{32}$ and $Q_{33}$, $Q_{34}$ are inserted in the bit lines and the bases of these transistors are connected to the wiring AL and the relevant bit line becomes effective only when these transistors are all OFF. Read transistors $Q_{35}$, $Q_{36}$, $Q_{37}$ are also connected to the bit lines and their bases are arranged to receive a read level (R) in common and thereby these transistors can read stored data by forming a current switch in combination with the ON transistor of a memory cell connected to a selected word line (for example, when $MC_{11}$ is selected and its left side transistor is ON, $Q_{35}$ is OFF, while $Q_{36}$ is ON, thus a current does not flow into one line of a sense amplifier but does flow into the other line and thereby the sense amplifier SA can detect the stored content of $MC_{11}$). However, when bit line transistors $Q_{31}$ and $Q_{32}$ in this example, become ON, the bit lines $B_{00}$, $B_{01}$ are clamped to the voltage $V_{DD}-2V_{BE}$ ($V_{BE}$=base-emitter difference of $Q_{40}$ and $Q_{31}$ or $Q_{32}$), currents of current sources $J_2$, $J_3$ are supplied from $Q_{31}$, $Q_{32}$ and the sense amplifier SA can no longer detect a signal. When a memory selects memory cells in the manner explained above, the read level in non-selected condition can be increased by clamping all of the decoders lines AL to H level under a condition in which a chip is not selected. Namely, when a chip is not selected, the chip select signal CS is H, and therefore a point $P_3$ becomes H level. When this H level is applied to the base of a multi-emitter transistor $Q_{40}$ connected to the lines AL, $Q_{40}$ becomes ON and as a result lines AL becomes H level and all of the transistors $Q_{31}$, $Q_{32}$, . . . become ON, clamping the bit lines to the level of $V_{DD}-2V_{BE}$.

In the case of this memory, a base voltage for read transistor $Q_{35}$ is generated by a circuit as indicated in the lower left side of Figure 6. In other words, CS is L level and $P_3$ is L level when a chip is selected and a read operation is to be carried out. Therefore, a transistor $Q_{41}$ is OFF and a write enable signal WE is H level and as a result transistors $Q_{42}$, $Q_{43}$ are ON, a transistor $Q_{44}$ is OFF and a voltage at emitter point $P_3'$ of a transistor $Q_{45}$, becomes H level. Voltage of point $P_3'$ at this time becomes a read level R.

During a write operation, We is L level, transistors $Q_{42}$ and $Q_{43}$ are OFF, $Q_{44}$ is ON and transistors $Q_{46}$ and $Q_{51}$ become ON or OFF in dependence upon the level, H or L, of the input data signal $D_{in}$. When $Q_{44}$ becomes ON, the point $P_3'$ becomes L level and read transistors $Q_{35}$ to $Q_{37}$ become OFF and resultingly become invalid. When the transistors $Q_{46}$, $Q_{51}$ become ON or OFF in accordance with the input data signal $D_{in}$, the transistors $Q_{47}$, $Q_{48}$ become ON or OFF ($Q_{46}$ON, $Q_{48}$ OFF; $Q_{51}$ ON, $Q_{47}$ OFF), making write transistors $Q_{49}$, and $Q_{50}$ and $Q_{51}$ ON or OFF. Namely, the output terminals of transistors $Q_{47}$,

$Q_{48}$ correspond to the D, $\overline{D}$ lines, for writing data into the memory cells.

In Figure 6, $J_4$ is a current source, $R_5$ to $R_8$ are resistors, and W represents hold lines.

The embodiments of Figures 2, 3 and 5 operate to clamp the base voltage of a read transistor to a high level in a non-selected chip in read operation, the embodiment of Figure 6 operates to clamp the base voltage of a bit line selection transistor in a non-selected chip in read operation.

In Figures 2, 3, 5 and 6, the symbol $V_r$ is used to designate reference voltages (not necessarily all the same).

Even when a memory has a large capacity, only one chip is selected and one memory cell within the selected chip is written or read. Other chips and memory cells are not selected at all. However, an address is given to each chip whether selected or non-selected, and the word line of a non-selected chip corresponding to a selected word line of a selected chip becomes H level. At this time, therefore, if noise appears on a bit line, a problem such as erroneous writing can occur. When all bit line levels are clamped to a H level in the non-selected chips, as in embodiments of the present invention, such erroneous writing can be prevented, effectively realizing safe and accurate protection of stored data.

An embodiment of this invention relates to a bipolar static type semiconductor memory device in which the influence of disturbances on the memory cells of non-selected chips is reduced and a large memory cell holding margin is obtained.

A semiconductor memory device embodying the present invention comprises memory cells, each of a flip-flop circuit structure, at respective intersection points of the word lines and bit lines. The memory holding margin of the memory cells is increased by providing a clamp means which clamps bit line voltage in a non-selected condition to a voltage higher than the bit line voltage in a read operation when a chip is selected.

An embodiment of the present invention provides a bipolar static type semiconductor memory chip having a chip select facility, including memory cells, each having a flip-flop circuit structure, arranged at intersection points of word lines and bit lines of the chip, wherein clamp means are provided which are operable, when the chip is non-selected, to clamp bit line voltage to a level higher than the bit line voltage level during a read operation when the chip is selected.

A semiconductor memory device embodying the present invention may comprise a plurality of chips as specified immediately above.

**Claims**

1. A semiconductor memory chip, having a chip select facility (CS), including memory cells ($MC_{11}$ to $MC_{22}$) arranged at intersection points of word lines ($W_1$, $W_2$) and bit lines ($B_{00}$, $B_{01}$, $B_{10}$, $B_{11}$) of the

chip, and bit line selection transistors ($Q_{31}$ to $Q_{34}$) connected to the bit lines, the chip further including clamp means ($Q_{40}$) which are operable, when the chip is non-selected (NS), to clamp bit line voltage to a level (RL) higher than the bit line voltage level (R) during a read operation when the chip is selected (SEL), the clamp means ($Q_{40}$) being arranged and operable for clamping the base voltage of the bit line selection transistors ($Q_{31}$ to $Q_{34}$).

2. A semiconductor memory chip, having a chip select facility (CS), including memory cells ($MC_{00}$ to $MC_{11}$) arranged at intersection points of word lines ($W_0$, $W_1$) and bit lines ($B_{00}$, $B_{01}$, $B_{10}$, $B_{11}$) of the chip and with a plurality of bit line pairs ($B_{00}$, $B_{01}$; $B_{10}$, $B_{11}$) having respective read transistor pairs ($Q_{10}$, $Q_{11}$) connected thereto, and a pair of data lines (D, $\overline{D}$), connected to the bases of the transistors of each read transistor pair ($Q_{10}$, $Q_{11}$), the chip further including clamp means (CL) which are operable to clamp the data lines (D, $\overline{D}$) and comprise a multi-emitter transistor ($Q_8$) having respective emitters connected to respective data lines (D, $\overline{D}$), a collector connected to a high level power supply line ($V_{DD}$) and a base connected to receive a voltage ($P_1$) which turns the multi-emitter transistor ($Q_8$) ON when the chip is non-selected (NS) and which turns the multi-emitter transistor ($Q_8$) OFF when the chip is selected (SEL), whereby when the chip is non-selected (NS), bit line voltage is clamped to a level (RL) higher than the bit line voltage level (R) during a read operation when the chip is selected (SEL).

3. A semiconductor memory chip having a chip select facility (CS), including memory cells ($MC_{00}$ to $MC_{11}$) arranged at intersection points of word lines ($W_0$, $W_1$) and bit lines ($B_{00}$, $B_{01}$, $B_{10}$, $B_{11}$) of the chip and with a plurality of bit line pairs ($B_{00}$, $B_{01}$; $B_{10}$, $B_{11}$) having respective read transistor pairs ($Q_{10}$, $Q_{11}$) connected thereto, and a pair of data lines (D, $\overline{D}$), connected to the bases of the transistors of each read transistor pair ($Q_{10}$, $Q_{11}$), the chip further including clamp means which are operable to clamp the data lines and comprise a pair of current switches (CW1, CW2) connected to respective data lines (D, $\overline{D}$) and arranged so that they are ON for passage of a high level voltage to the data lines, when the chip is non-selected (NS), and are OFF for passage of that high level voltage when the chip is selected (SEL), whereby when the chip is non-selected (NS), bit line voltage is clamped to a level (RL) higher than the bit line voltage level (R) during a read operation when the chip is selected (SEL).

4. A chip as claimed in claim 1, having a plurality of address lines (AL) selectively connected to the bases of the bit line selection transistor ($Q_{31}$ to $Q_{34}$), wherein the clamp means are operable to clamp the address lines (AL) and comprise a multi-emitter transistor ($Q_{40}$) having respective emitters connected to respective address lines (AL), a collector connected to a high level power supply line ($V_{DD}$ and a base connected to receive a voltage ($P_3$) which turns the multi-

emitter transistor ($Q_{40}$) ON when the chip is non-selected and which turns the multi-emitter transistor ($Q_{40}$) OFF when the chip is selected.

5. A semiconductor memory device, including a plurality of chips as claimed in any preceding claim.

**Patentansprüche**

1. Halbleiterspeicherchip, mit einer Chipauswahleinrichtung (CS), die Speicherzellen ($MC_{11}$ bis $MC_{22}$) umfaßt, die an Kreuzungspunkten von Wortleitungen ($W_1$, $W_2$) und Bitleitungen ($B_{00}$, $B_{01}$, $B_{10}$, $B_{11}$) des Chips angeordnet sind, und Bitleitungsauswahltransistoren ($Q_{31}$ bis $Q_{34}$), die mit den Bitleitungen verbunden sind, wobei das Chip ferner Klemmeinrichtungen ($Q_{40}$) umfaßt, die betreibbar sind, wenn das Chip nicht ausgewählt (NS) ist, um die Bitleitungsspannung auf einen Pegel (RL) zu klemmen, der höher als der Bitleitungsspannungspegel (R) während des Lesebetriebs ist, wenn das Chip ausgewählt (SEL) ist, wobei die Klemmeinrichtung ($Q_{40}$) zum Klemmen der Basisspannung der Bitleitungsauswahltransistoren ($Q_{31}$ bis $Q_{34}$) angeordnet und betreibbar ist.

2. Halbleiterspeicherchip mit einer Chipauswahleinrichtung (CS), die Speicherzellen ($MC_{00}$ bis $MC_{11}$) umfaßt, die an Kreuzungspunkten von Wortleitungen ($W_0$, $W_1$) und Bitleitungen ($B_{00}$, $B_{01}$, $B_{10}$, $B_{11}$) des Chips angeordnet sind, und einer Vielzahl von Bitleitungspaaren ($B_{00}$, $B_{01}$; $B_{10}$, $B_{11}$), die jeweils Lesetransistorpaare ($Q_{10}$, $Q_{11}$) umfassen, die mit ihnen verbunden sind, und ein Paar von Daten- leitungen (D, $\overline{D}$), die mit den Basen der Transistoren von jedem Lesetransistorpaar ($Q_{10}$, $Q_{11}$) verbunden sind, wobei das Chip ferner Klemmeinrichtungen (CL) umfaßt, die betreibbar sind, um die Datenleitungen (D, $\overline{D}$) zu klemmen und Multiemittertransistoren ($Q_8$) umfassen, die jeweils Emitter haben, die mit entsprechenden Datenleitungen (D, $\overline{D}$) verbunden sind, einen Kollektor, der mit einer Hochpegel - Energieversorgungsleitung ($V_{DD}$) verbunden ist, und eine Basis, die angeschlossen ist, um eine Spannung ($P_1$) zu empfangen, die den Multiemittertransistor ($Q_8$) EIN schaltet, wenn das Chip nicht ausgewählt (NS) ist, und die den Multiemittertransistor ($Q_8$) AUS schaltet, wenn das Chip ausgewählt (SEL) ist, wodurch dann, wenn das Chip nicht ausgewählt (NS) ist, die Leitungsspan- nung auf einen Pegel (RL) geklemmt wird, der höher als der Bitleitungsspannungspegel (R), während des Lesebetriebs ist, wenn das Chip ausgewählt (SEL) ist.

3. Halbleiterspeicherchip, mit einer Chipauswahleinrichtung (CS), die Speicherzellen ($MC_{00}$ bis $MC_{11}$) umfaßt, die an Kreuzungspunkten von Wortleitungen ($W_0$, $W_1$) und Bitleitungen ($B_{00}$, $B_{01}$, $B_{10}$, $B_{11}$) des Chips angeordnet sind, und mit einer Viel- zahl von Bitleitungspaaren ($B_{00}$, $B_{01}$; $B_{10}$, $B_{11}$), die jeweils Lesetransistorpaare ($Q_{10}$, $Q_{11}$) haben, die an diese angeschlossen sind, und ein Paar von Datenleitungen (D, $\overline{D}$), die mit den Basen der Transistoren von jedem Lesetransistorpaar ($Q_{10}$,

$Q_{11}$) verbunden sind, wobei das Chip ferner Klemm- einrichtungen umfaßt, welche betreibbar sind, um die Datenleitungen zu klemmen und die ein Paar von Strom- schaltern (CW$_1$, CW$_2$) umfassen, die mit jeweiligen Datenleitungen (D, $\overline{D}$) verbunden und so angeordnet sind, daß sie für den Durchgang der Hochpegelspannung zu den Datenleitungen EIN sind, wenn das Chip nicht ausgewählt (NS) ist, und die für den Durchgang von dieser Hochpegelspannung AUS sind, wenn das Chip ausgewählt (SEL) ist, wodurch dann, wenn das Chip nicht ausgewält (NS) ist, die Bitleitungsspannung auf einen Pegel (RL) geklemmt wird, der höher als der Bitleitungsspannungspegel (R) während eines Lesebetriebs ist, wenn das Chip ausgewählt (SEL) ist.

4. Chip nach Anspruch 1, mit einer Vielzahl von Adressenleitungen (AL), die selektiv mit den Basen des Bitleitungsauswahltransistors ($Q_{31}$ bis $Q_{34}$) verbunden sind, wodurch die Klemmeinrichtung betreibbar ist, um die Adressenleitungen (AL) zu klemmen, und einen Multi- emittertransistor ($Q_{40}$) umfaßt, der jeweilige Emitter hat, die mit entsprechenden Adressenleitungen (AL) verbunden sind, einen Kollektor, der mit einer Hochpegel - Energieversorgungsleitung ($V_{DD}$) verbunden ist, und eine Basis, die zum Empfang einer Spannung ($P_3$) angeschlossen ist, die den Multiemittertransistor ($Q_{40}$) EIN schaltet, wenn das Chip nicht ausgewählt ist, und die den Multiemittertransistor ($Q_{40}$) AUS schaltet, wenn das Chip ausgewählt ist.

5. Halbleiterspeichervorrichtung mit einer Vielzahl von Chips nach einem der vorhergehenden Ansprüche.

**Revendications**

1. Circuit intégré ou puce de mémoire à semiconducteur, comportant un moyen de sélection de puces (CS), incluant des cellules de mémoire (MC$_{11}$ à MC$_{22}$) disposées aux points d'intersection de fils de mot (W$_1$, W$_2$) et de fils de bit (B$_{00}$, B$_{01}$, B$_{10}$, B$_{11}$) de la puce, et des transistors de sélection de fils de bit ($Q_{31}$ à $Q_{34}$) connectés aux fils de bit, la puce incluant en outre des moyens de blocage ($Q_{40}$) qui peuvent être mis en fonctionnement, quand la puce est non sélectionnée (NS), pour bloquer la tension de fil de bit à un niveau (RL) supérieur au niveau de tension de fil de bit (R) pendant une opération de lecture quand la puce est sélectionnée (SEL), les moyens de blocage ($Q_{40}$) étant disposés et pouvant fonctionner pour bloquer la tension de base des transistors de sélection de fils de bit ($Q_{31}$ à $Q_{34}$).

2. Puce de mémoire à semiconducteur, comportant un moyen de sélection de puces (CS), incluant des cellules de mémoire (MC$_{00}$ à MC$_{11}$) disposées aux points d'intersection de fils de mot (W$_0$, W$_1$) et de fils de bit (B$_{00}$, B$_{01}$, B$_{10}$, B$_{11}$) de la puce, un ensemble de paires de fils de bit (B$_{00}$, B$_{01}$; B$_{10}$, B$_{11}$) comportant des paires de transistors de lecture respectives ($Q_{10}$, $Q_{11}$) connectées à celles-ci, et une paire de fils de données (D, $\overline{D}$), connectés aux bases des transistors de chaque paire de transistors de lecture ($Q_{10}$, $Q_{11}$), la puce incluant en outre des moyens de blocage (CL) qui peuvent être mis en fonctionnement pour bloquer les fils de données (D, $\overline{D}$) et comprennent un transistor à plusieurs émetteurs ($Q_8$) comportant des émetteurs respectifs connectés aux fils de données (D, $\overline{D}$) respectifs, un collecteur connecté à un fil de tension d'alimentation de niveau haut ($V_{DD}$) et une base connectée pour recevoir une tension ($P_1$) qui rend conducteur le transistor à plusieurs émetteurs ($Q_8$) quand la puce est non sélectionnée (NS) et qui met à l'état bloqué le transistor à plusieurs émetteurs ($Q_8$) quand la puce est sélectionnée (SEL), la tension de fil de bit étant ainsi bloquée, quand la puce est non sélectionnée (NS), à un niveau (RL) supérieur au niveau de tension de fil de bit (R) pendant une opération de lecture quand la puce est sélectionnée (SEL).

3. Puce de mémoire à semiconducteur, comportant un moyen de sélection de puces (CS), incluant des cellules de mémoire (MC$_{00}$ à MC$_{11}$) disposées aux points d'intersection de fils de mot (W$_0$, W$_1$) et de fils de bit (B$_{00}$, B$_{01}$, B$_{10}$, B$_{11}$) de la puce, un ensemble de paires de fils de bit (B$_{00}$, B$_{01}$; B$_{10}$, B$_{11}$) comportant des paires de transistors de lecture respectives ($Q_{10}$, $Q_{11}$) connectées à celles-ci, et une paire de fils de données (D, $\overline{D}$), connectés aux bases des transistors de chaque paire de transistors de lecture ($Q_{10}$, $Q_{11}$), la puce incluant en outre des moyens de blocage qui peuvent être mis en fonctionnement pour bloquer les fils de donnée et comprennent une paire de commutateurs de courant (CW$_1$, CW$_2$) connectés aux fils de données respectifs (D, $\overline{D}$) et disposés de telle sorte qu'ils sont conducteurs pour laisser passer une tension de niveau haut jusqu'aux fils de donnée, quand la puce est non sélectionnée (NS), et qu'ils sont bloqués pour ne pas laisser passer cette tension de niveau haut quand la puce est sélectionnée (SEL), la tension de fil de bit étant ainsi bloquée, quand la puce est non sélectionnée (NS), à un niveau (RL) supérieur au niveau de tension de fil de bit (R) pendant une opération de lecture quand la puce est sélectionnée (SEL).

4. Puce selon la revendication 1, comportant un ensemble de fils d'adresse (AL) connectés sélectivement aux bases des transistors de sélection de fils de bit ($Q_{31}$ à $Q_{34}$), dans laquelle les moyens de blocage peuvent être mis en fonctionnement pour bloquer les fils d'adresse (AL) et comprennent un transistor à plusieurs émetteurs ($Q_{40}$) comportant des émetteurs respectifs connectés aux fils d'adresse respectifs (AL), un collecteur connecté pour recevoir une tension ($P_3$) qui rend conducteur le transistor à plusieurs émetteurs ($Q_{40}$) quand la puce est non sélectionnée et qui met à l'état bloqué le transistor à plusieurs émetteurs ($Q_{40}$) quand la puce est sélectionnée.

5. Dispositif de mémoire à semiconducteur, incluant un ensemble de puces telles que revendiquées dans l'une quelconque des revendica- tions 1 à 4.

Fig 1

Fig.2

Fig. 3

Fig. 4

Fig. 5

Fig. 6